# EUROPEAN PATENT APPLICATION

(11) **EP 4 632 990 A1**
(43) Date of publication of application: **15.10.2025**
(21) Application number: 23900448.4
(22) Date of filing: 21.11.2023
(51) Int. Cl.: H02J 7/00, G01R 31/382, G01R 31/385, G01R 31/392, H01M 10/42, H01M 10/48

(54) **DETERIORATION SUPPRESSION SYSTEM, DETERIORATION SUPPRESSION METHOD, DETERIORATION SUPPRESSION PROGRAM, AND STORAGE MEDIUM HAVING DETERIORATION SUPPRESSION PROGRAM WRITTEN THEREIN**

(30) Priority: 07.12.2022 JP 2022195568
(71) Applicant: Panasonic Intellectual Property Management Co., Ltd., Kadoma-shi, Osaka 571-0057 (JP)
(72) Inventor: MATSUDA Takashi, Kadoma-shi, Osaka 571-0057 (JP); YANG Changhui, Kadoma-shi, Osaka 571-0057 (JP)
(74) Representative: Novagraaf International SA
(86) International application number: PCT/JP2023/041750
(87) International publication number: WO 2024/122329

(57) **Abstract**

A histogram generation unit generates a histogram of a duration of stay time of state of charge (SOC) of a battery based on battery data. An actual SOC range calculation unit specifies, as an actual SOC use range, an SOC range within a predetermined appearance probability from the histogram. A recommended SOC range calculation unit calculate a recommended SOC use range in which deterioration is more suppressed than the actual SOC use range based on a statistical charge and discharge pattern based on the actual SOC use range and the battery data, with refers to deterioration characteristics of the battery. A display controller causes a display unit to display a display prompting a user to use the battery in the recommended SOC use range.

## Description

### TECHNICAL FIELD

The present disclosure relates to a deterioration suppression system, a deterioration suppression method, and a deterioration suppression program for suppressing deterioration of a battery.

### BACKGROUND ART

In recent years, with an increase in a capacity of a battery, there is no need to constantly charge a device on which a rechargeable battery is mounted to full charge depending on a use method of a user. In addition, the battery is increasingly used without charging every day. Accordingly, in order to set the battery to be last longer, it has been desired to systematically charge the battery as much as necessary.

However, since a general rechargeable product (for example, a smartphone, a cleaning robot, or the like) can be easily charged, a charge timing and the amount of electricity used until a next charge vary depending on an individual, and it is difficult to prepare a versatile optimal charge plan. In addition, a specification that causes the user to input a use condition such as the amount of electricity used until the next charge takes a time and effort for the user, and a burden on the user increases. In addition, even in a device that is charged every day by a periodic operation like a delivery vehicle, the amount of electricity required for traveling tomorrow varies depending on various conditions (for example, season, day of the week, weather, occurrence of traffic jam, and the like), and it is not easy to create an optimal charge plan.

Regarding creation of a charge plan for suppressing deterioration, PTL 1 discloses a method for learning a charge end time with a neural network to shorten a retention time of full charge and creating a charge plan. PTL 2 discloses a method for estimating a use timing based on a use history of a content and creating a charge plan to be fully charged according to a use timing. In such a method for charging to full charge, there is a case where optimal charge is not achieved in a large-capacity battery. In addition, even when the plan is wrong, there is a case where optimal charge is not achieved. PTL 3 discloses a method for creating a charge plan from schedule information of a user. In this method, it is necessary for the user to input a schedule, and this method takes a time and effort.

### Citation List

### Patent Literature

PTL 1: International Publication No. WO 18/215864
PTL 2: Unexamined Japanese Patent Publication No. 2012-019600
PTL 3: Unexamined Japanese Patent Publication No. 2001-184144

### SUMMARY OF THE INVENTION

The present disclosure has been made in view of such a situation, and an object of the present disclosure is to provide a technique for promoting a user to use a battery in which deterioration is suppressed to be suitable for each user without requiring input of use conditions.

In order to solve the above problem, a deterioration suppression system according to one aspect of the present disclosure includes a histogram generation unit that generates a histogram of a duration of stay time of state of charge (SOC) of a battery based on battery data acquired from the battery, an actual SOC range calculation unit that calculates, as an actual SOC use range, an SOC range that falls within a predetermined appearance probability from the histogram, and a recommended SOC range calculation unit that calculate a recommended SOC use range in which deterioration is more suppressed than the actual SOC use range based on a statistical charge and discharge pattern based on the actual SOC use range and the battery data refers to deterioration characteristics of the battery, and a display controller that causes a display unit to display a display prompting a user to use the battery in the recommended SOC use range.

Any combinations of configuration elements described above and expressions of the present disclosure that are converted in terms of devices, systems, methods, computer programs, recording medium, and the like are also effective as aspects of the present disclosure.

According to the present disclosure, it is possible to promote use of a battery in which deterioration is suppressed to be suitable for each user without requiring input of a use condition.

### BRIEF DESCRIPTION OF THE DRAWINGS

Fig. 1 is a diagram for explaining a battery-mounted device according to an exemplary embodiment.
Fig. 2 is a diagram illustrating functional blocks of a controller and a storage unit of the battery-mounted device in Fig. 1.
Fig. 3 is a diagram illustrating an example of a histogram of an duration of stay time of SOC.
Fig. 4A is a diagram illustrating a schematic example of a storage deterioration characteristic map.
Fig. 4B is a diagram illustrating a schematic example of a charge deterioration characteristic map.
Fig. 4C is a diagram illustrating a schematic example of a discharge deterioration characteristic map.
Fig. 5 is a diagram illustrating an example of a charge route search.
Fig. 6 is a diagram illustrating an example of an actual charge and discharge pattern and an ideal charge and discharge pattern.
Fig. 7 is a diagram illustrating an example of an actual SOC use range and an ideal SOC use range for each user.
Fig. 8 is a diagram illustrating an example of normalization of a display SOC.
Fig. 9A is a diagram illustrating a display example of a remaining battery level.
Fig. 9B is a diagram illustrating a display example of the remaining battery level.
Fig. 10 is a flowchart illustrating a switching control example of a battery mode in the battery-mounted device according to the exemplary embodiment.

### DESCRIPTION OF EMBODIMENT

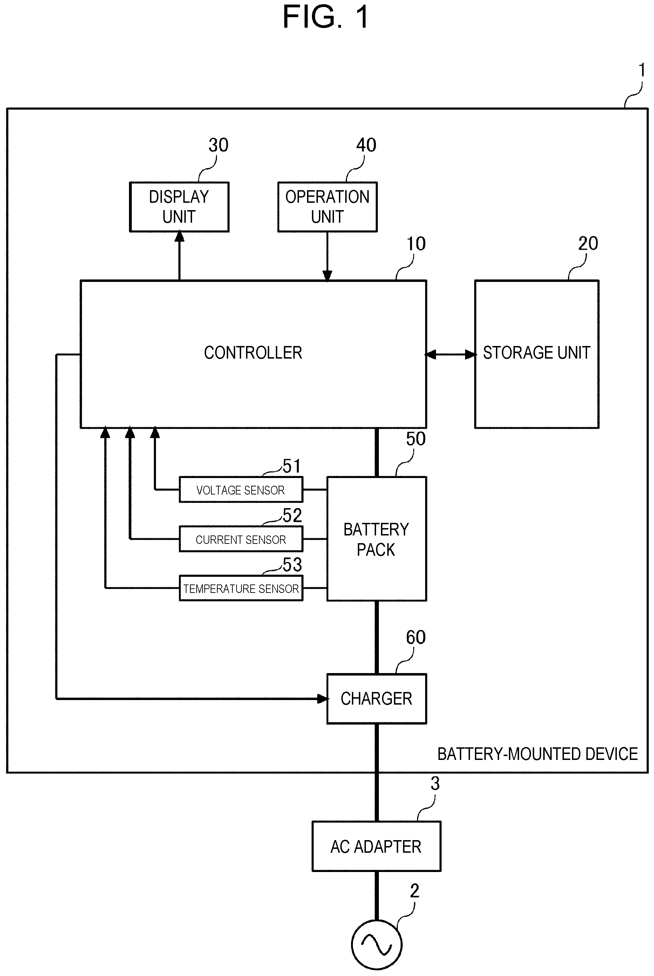

Fig. 1 is a diagram for explaining battery-mounted device 1 according to an exemplary embodiment. Battery-mounted device 1 according to the exemplary embodiment is a device on which a chargeable and dischargeable battery pack 50 is mounted. Examples of battery-mounted device 1 include a portable information terminal (for example, a smartphone, a tablet, or a notebook PC), some home electric appliances (for example, a cleaning robot), an electric vehicle, an electric motorcycle, an electric bicycle, an electric kick scooter, a multi-copter (drone), and the like. Hereinafter, in the present exemplary embodiment, a smartphone is assumed.

Battery-mounted device 1 includes controller 10, storage unit 20, display unit 30, operation unit 40, battery pack 50, voltage sensor 51, current sensor 52, temperature sensor 53, and charger 60. Battery pack 50 is formed by connecting a plurality of cells or a plurality of parallel cell blocks in series. Each parallel cell block is formed by connecting a plurality of cells in parallel. For each of the cells, a lithium-ion battery cell, a nickel metal hydride battery cell, a lead battery cell, or the like can be used. Hereinafter, the present description assumes an example of use of lithium-ion battery cells (nominal voltage: 3.6 V to 3.7 V).

Voltage sensor 51 detects voltages of cells connected in series or parallel cell blocks. Current sensor 52 detects a current flowing through the cell or the parallel cell block connected in series based on a voltage across a shunt resistor. The plurality of cells or the plurality of parallel cell blocks connected in series are connected to the shunt resistor in series. Instead of the shunt resistor, a Hall element may be used. Temperature sensor 53 detects temperatures of the plurality of cells or the parallel cell blocks based on a divided voltage of a thermistor and a resistor installed in at least one of the plurality of cells or the parallel cell blocks. The voltages detected by voltage sensor 51, the currents detected by current sensor 52, and the temperatures detected by temperature sensor 53 are output to controller 10.

Controller 10 integrally controls entire battery-mounted device 1. Functions of controller 10 can be achieved by cooperation of a hardware resource and a software resource, or by the hardware resource alone. Available examples of the hardware resource include a CPU, a ROM, a RAM, a graphics processing unit (GPU), an application specific integrated circuit (ASIC), a field programmable gate array (FPGA), and other LSI circuits. As the software resource, an operating system, an application, and another program can be used. The CPU executes a program stored in a memory, and thus, a computer functions as controller 10. In this example, the program is recorded in advance in the memory of controller 10. Alternatively, the program may be provided via a telecommunication line such as the Internet or by being recorded in a (non-transitory) recording medium such as a memory card.

Storage unit 20 includes a nonvolatile recording medium (NAND flash memory or the like) and stores various kinds of data. Display unit 30 includes a liquid crystal display, an organic EL display, a mini LED display, and the like, and displays an image supplied from controller 10. Operation unit 40 includes a physical button and a touch panel, receives an operation of a user, and outputs an operation signal based on an operation content to controller 10. A touch panel display in which functions of display unit 30 and operation unit 40 are integrated may be used.

Battery pack 50 can be charged from commercial power system 2. A charge terminal of battery pack 50 is connected to commercial power system 2 via charger 60 and AC adapter 3. AC adapter 3 converts an AC voltage of 100/200 V input from commercial power system 2 into a DC voltage of about 5 V to 12 V, and outputs the DC voltage. In a case where battery-mounted device 1 is a notebook PC, AC adapter 3 converts the AC voltage into a DC voltage of about 14 V to 20 V and outputs the DC voltage.

Charger 60 includes a DC/DC converter. The DC/DC converter (for example, a switching regulator) controls a current or a voltage of a DC power supplied from AC adapter 3 according to a current command value or a voltage command value supplied from controller 10, and outputs the DC power of the current or the voltage specified by the command value to battery pack 50.

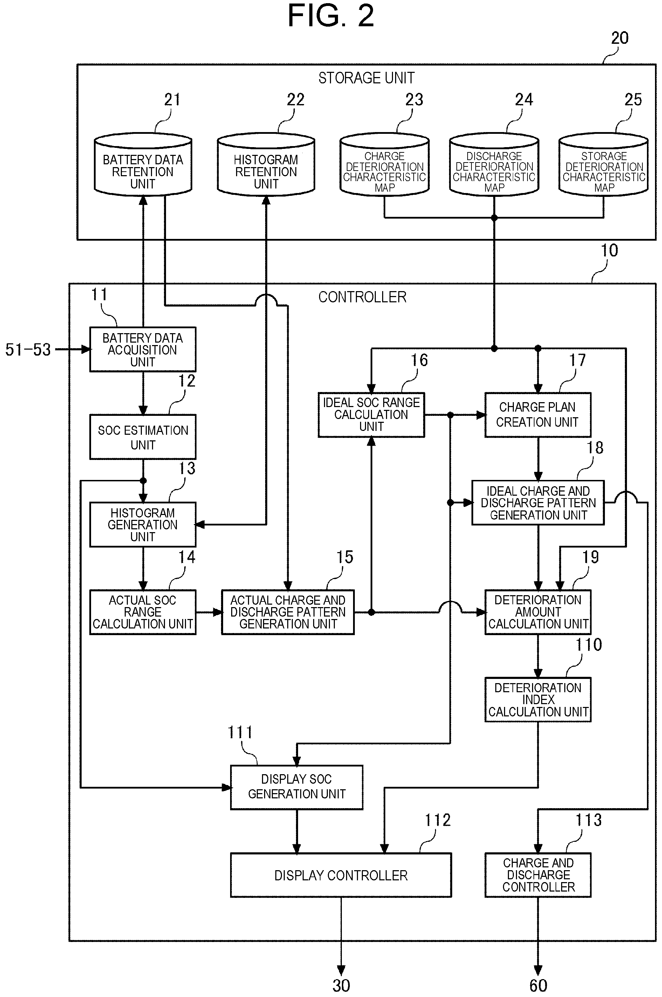

Fig. 2 is a diagram illustrating functional blocks of controller 10 and storage unit 20 of battery-mounted device 1 of Fig. 1. The functional blocks illustrated in Fig. 2 depict only functional blocks related to a deterioration suppression system of battery pack 50 according to the present exemplary embodiment. These function blocks include controller 10, battery data acquisition unit 11, SOC estimation unit 12, histogram generation unit 13, actual SOC range calculation unit 14, actual charge and discharge pattern generation unit 15, ideal SOC range calculation unit 16, charge plan creation unit 17, ideal charge and discharge pattern generation unit 18, deterioration amount calculation unit 19, deterioration index calculation unit 110, display SOC generation unit 111, display controller 112, and charge and discharge controller 113. Storage unit 20 includes battery data retention unit 21, histogram retention unit 22, charge deterioration characteristic map 23, discharge deterioration characteristic map 24, and storage deterioration characteristic map 25.

Battery data acquisition unit 11 acquires battery data including a voltage, a current, and a temperature of each cell or each parallel cell block included in battery pack 50 from voltage sensor 51, current sensor 52, and temperature sensor 53 at a predetermined sampling cycle (for example, every 10 seconds, every 1 minute).

SOC estimation unit 12 estimates an SOC by a combination of an open circuit voltage (OCV) method and a current integration method. The OCV method is a method for estimating the SOC based on an OCV of each cell or each parallel cell block measured by voltage sensor 51 and an SOC-OCV curve of the cell. The SOC-OCV curve of the cell is created in advance based on a characteristic test by a battery manufacturer, and is registered in the ROM of controller 10 at the time of shipment.

The current integration method is a method for estimating the SOC based on an OCV at the start of charge and discharge of each cell and an integrated value of the currents measured by current sensor 52. The current integration method causes a measurement error of current sensor 52 to accumulate as charge and discharge times increase. On the other hand, the OCV method is affected by a measurement error of voltage sensor 51 and an error due to a polarization voltage. Thus, the SOC estimation unit preferably uses a value obtained by weight-averaging the SOC estimated by the current integration method and the SOC estimated by the OCV method.

SOC estimation unit 12 estimates the SOC of battery pack 50 based on the SOC of each cell or each parallel cell block. Battery data acquisition unit 11 accumulates the battery data including the voltage, the current, the temperature, and the SOC of each cell or each parallel cell block in battery data retention unit 21.

Histogram generation unit 13 creates a histogram of a duration of stay time of the SOC of battery pack 50. Histogram generation unit 13 generates a histogram of a duration of stay time for each SOC (for example, 1% increments or 5% increments). The histogram reflects a use state of battery pack 50 of the user. Histogram generation unit 13 may create a histogram of the SOC for the entire period from the start of use of battery pack 50, or may create a histogram of the SOC for a latest predetermined period (for example, 30 days). In the latter case, unnecessary battery data may be deleted as appropriate.

Histogram generation unit 13 may generate the histogram of the duration of stay time of SOC for each weekday and holiday or for each day of the week. In addition, histogram generation unit 13 may generate a histogram in which data is weighted such that a weight of data closest to latest data increases. Histogram generation unit 13 stores the generated histogram in histogram retention unit 22.

Actual SOC range calculation unit 14 fits the histogram of the duration of stay time of SOC by using a Gaussian function, and specifies an SOC range that falls within a predetermined appearance probability as an actual SOC use range. For example, actual SOC range calculation unit 14 specifies an SOC range that falls within a range of u ± kσ as the actual SOC use range. In a case where k is a constant, and for example, k = 2 is set, an SOC range in which about 95% of the SOC falls can be specified. Since data near SOC = 100% and data near SOC = 0% may be left for a long period, it is preferable to exclude the data from a target when the histogram is fitted to a normal distribution.

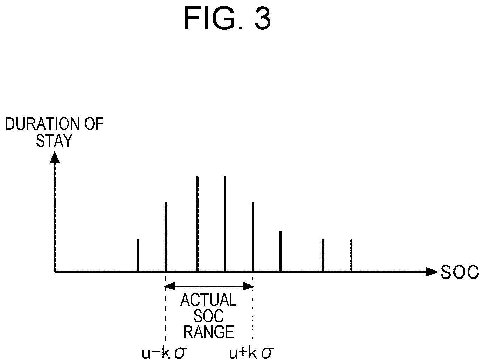

Fig. 3 is a diagram illustrating an example of the histogram of the duration of stay time of SOC. A horizontal axis represents SOC "%", and a vertical axis represents a duration of stay time [h]. Actual SOC range calculation unit 14 fits the histogram by using the Gaussian function, and specifies the SOC range that falls within the range of u ± kσ as the actual SOC use range.

The description refers back to Fig. 2. Actual charge and discharge pattern generation unit 15 acquires battery data in a target period corresponding to a histogram generation period of the duration of stay time of SOC from battery data retention unit 21. Actual charge and discharge pattern generation unit 15 generates an actual charge and discharge pattern based on current data in the target period. In the present exemplary embodiment, the actual charge and discharge pattern refers to a statistical charge and discharge pattern of one cycle including a charge period and a discharge period.

Actual charge and discharge pattern generation unit 15 calculates an average value of charge times. The average value is a representative value of the charge times, and a median value or a mode value may be used instead of the average value. Actual charge and discharge pattern generation unit 15 calculates an average value of charge intervals. The charge interval refers to a period from the end of a certain charge to the start of the next charge. Actual charge and discharge pattern generation unit 15 sets a period obtained by adding an average charge time and an average charge interval as a period of the actual charge and discharge pattern. Histogram generation unit 13 may calculate a weighted average value of the charge time and a weighted average value of the charge interval such that the weight of the data closest to the latest data increases, and may add the weighted average value and the weighted average value to set the period of the actual charge and discharge pattern. In this case, a more recent use tendency can be reflected.

Actual charge and discharge pattern generation unit 15 assumes that a power amount corresponding to a depth of discharge (DOD) in the actual SOC use range is charged in every charge and that the power amount is charged at a constant current in a charge period of the actual charge and discharge pattern, and generates a current pattern in the charge period of the actual charge and discharge pattern. Actual charge and discharge pattern generation unit 15 assumes that the power amount is discharged at a constant current in one charge interval, and generates a current pattern in a non-charge period (combination of a discharge period and a pausing period) of the actual charge and discharge pattern.

In a case where the current pattern in the charge period can be extracted from past battery data, actual charge and discharge pattern generation unit 15 may use the extracted current pattern as the current pattern in the charge period of the actual charge and discharge pattern. Similarly, in a case where a current pattern in the non-charge period in the actual charge and discharge pattern can be extracted from the past battery data, actual charge and discharge pattern generation unit 15 may use the extracted current pattern as the current pattern in the non-charge period of the actual charge and discharge pattern. For example, in the case of timer type battery-mounted device 1, when the charge period is excluded, the battery is basically discharged in a set time zone, and the remaining time zone is paused. In this case, actual charge and discharge pattern generation unit 15 can clearly divide the current pattern in the non-charge period in the actual charge and discharge pattern into the discharge period and the pause period.

Charge deterioration characteristic map 23, discharge deterioration characteristic map 24, and storage deterioration characteristic map 25 are obtained by mapping charge deterioration characteristics, discharge deterioration characteristics, and storage deterioration characteristics of the cells included in battery pack 50. The charge deterioration characteristics, the discharge deterioration characteristics, and the storage deterioration characteristics of the cells are derived in advance by experiments and simulations by battery manufacturers. Data derived from other evaluation organizations may be used.

Storage deterioration is deterioration that progresses over time in accordance with a temperature at each time point and an SOC at each time point of the cell. The storage deterioration progresses as time goes, regardless of whether or not charge or discharge is being performed. The storage deterioration mainly occurs due to formation of a solid electrolyte interphase (SEI) film on a negative electrode. The storage deterioration depends on the SOC and temperature at each time point. In general, the higher the SOC at each time point is or the higher the temperature at each time point is, the more a storage deterioration rate increases.

Charge and discharge deterioration is deterioration that progresses with increase in a number of times of charging and discharging. The charge and discharge deterioration mainly occurs due to cracking or peeling by expansion or contraction of an active material. The charge and discharge deterioration depends on a current rate, an SOC range to be used, and a temperature. In general, the higher the current rate is, the wider the SOC range to be used is, and the higher the temperature is, the more a charge and discharge deterioration rate increases.

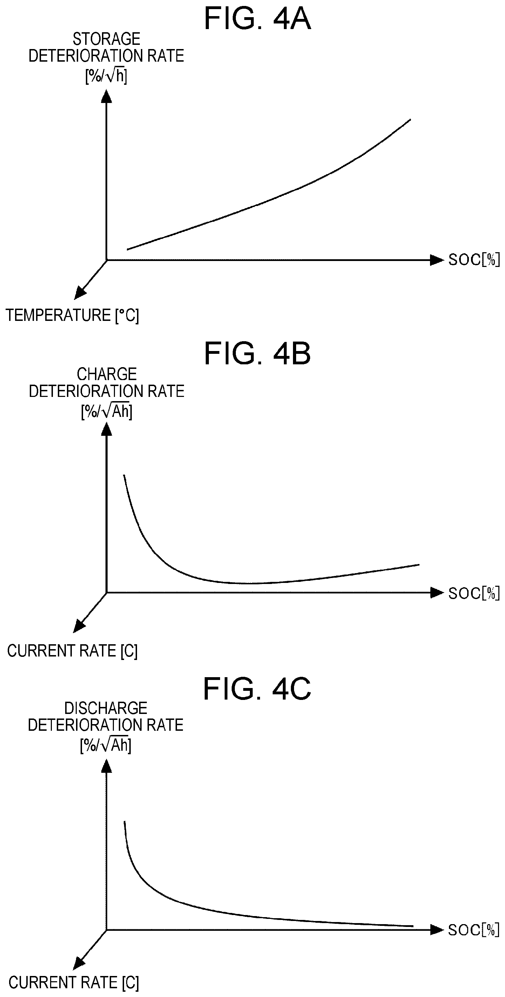

Fig. 4A illustrates a schematic example of the storage deterioration characteristic map. An X-axis represents an SOC [%], a Y-axis represents a temperature [°C], and a Z-axis represents a storage deterioration rate [%/√h]. In general, the storage deterioration progresses substantially linearly with respect to a value obtained by raising elapsed time (h) to the power of 0.5 (square root). Depending on a type of the cell, elapsed time (h) may progress substantially linearly with respect to a value obtained by raising elapsed time (h) to the power of 0.4, a value obtained by raising elapsed time (h) to the power of 0.6, or the like. As illustrated in Fig. 4A, the higher the SOC is, the faster the storage deterioration rate becomes.

Fig. 4B illustrates a schematic example of the charge deterioration characteristic map. An X-axis represents an SOC use range [%], a Y-axis represents a current rate [C], and a Z-axis represents a charge deterioration rate [%/√Ah]. Fig. 4C illustrates a schematic example of the discharge deterioration characteristic map. An X-axis represents an SOC use range [%], a Y-axis represents a current rate [C], and a Z-axis represents a discharge deterioration rate [%/√Ah]. In general, the charge and discharge deterioration progresses substantially linearly with respect to a value obtained by raising total charge amount or total discharge amount (Ah) to the power of 0.5 (square root). Depending on the type of the cell, charge amount or discharge amount (Ah) may progress substantially linearly with respect to a value obtained by raising total charge amount or total discharge amount (Ah) to the power of 0.4 or a value obtained by raising total charge amount or total discharge amount (Ah) to the power of 0.6.

As illustrated in Fig. 4B, charging in a low SOC region increases the charge deterioration rate. In addition, in a case of charging in a high SOC region, the charge deterioration rate becomes faster, although not as much as in the low SOC region. In addition, as illustrated in Fig. 4C, the discharge deterioration rate increases as the discharge is performed in a region where the SOC is low.

The charge and discharge deterioration characteristics do not contribute as much as the current rate does, but are also affected by temperature. Thus, in order to raise the estimation accuracy of the charge and discharge deterioration rate, it is preferable to prepare charge and discharge deterioration characteristics in which a relationship between the SOC use range and the charge and discharge deterioration rate is defined for each two-dimensional combination of a plurality of current rates and a plurality of temperatures. On the other hand, in a case where a simple charge and discharge deterioration characteristic map is generated, the temperature is regarded as a normal temperature, and charge and discharge deterioration characteristics for each of a plurality of current rates need only be prepared. The storage deterioration characteristic, the charge deterioration characteristic, and the discharge deterioration characteristic may be defined by a function instead of a map.

The description refers back to Fig. 2. Based on the actual SOC use range and the actual charge and discharge pattern, ideal SOC range calculation unit 16 refers to charge deterioration characteristic map 23, discharge deterioration characteristic map 24, and storage deterioration characteristic map 25, and searches for an SOC use range (hereinafter, referred to as an ideal SOC use range) having the same DOD as the actual SOC use range and a lowest deterioration. For example, ideal SOC range calculation unit 16 shifts the actual SOC use range in predetermined increments (for example, 5% increments or 1% increments), and calculates a deterioration amount in a case where charging and discharging of the actual charge and discharge pattern are performed in each SOC use range. Ideal SOC range calculation unit 16 determines the SOC range with a smallest deterioration amount as the ideal SOC use range. The ideal SOC use range indicates an optimal SOC use range of battery pack 50 to be recommended to the user.

Charge plan creation unit 17 creates a charge plan in which deterioration is more suppressed than the charge pattern, based on the charging time of the actual charge and discharge pattern, the ideal SOC use range, the charging degradation characteristic map 23, and the storage degradation characteristic map 25. Specifically, charge plan creation unit 17 creates a charge plan in which the deterioration amount is minimized when charging from a lower limit SOC to an upper limit SOC of the ideal SOC use range is performed in the charge time of the actual charge and discharge pattern. Hereinafter, an example in which an optimal charge plan is created will be described.

Charge plan creation unit 17 sets the lower limit SOC of the ideal SOC use range as a charge start SOC, and sets the upper limit SOC of the ideal SOC use range as a charge target SOC. Charge plan creation unit 17 sets a plurality of nodes with a predetermined increment size within an SOC section between the charge target SOC and the charge start SOC. Charge plan creation unit 17 sets a plurality of nodes at predetermined increment sizes within the charge period of the actual charge and discharge pattern.

Charge plan creation unit 17 sets paths between set matrix-shaped nodes. Charge plan creation unit 17 refers to charge deterioration characteristic map 23 and storage deterioration characteristic map 25 and assigns deterioration cost to the paths between the nodes. Charge plan creation unit 17 searches for a charge route that minimizes total deterioration cost of paths between the nodes. Charge plan creation unit 17 creates a current pattern corresponding to the searched charge route as a charge plan.

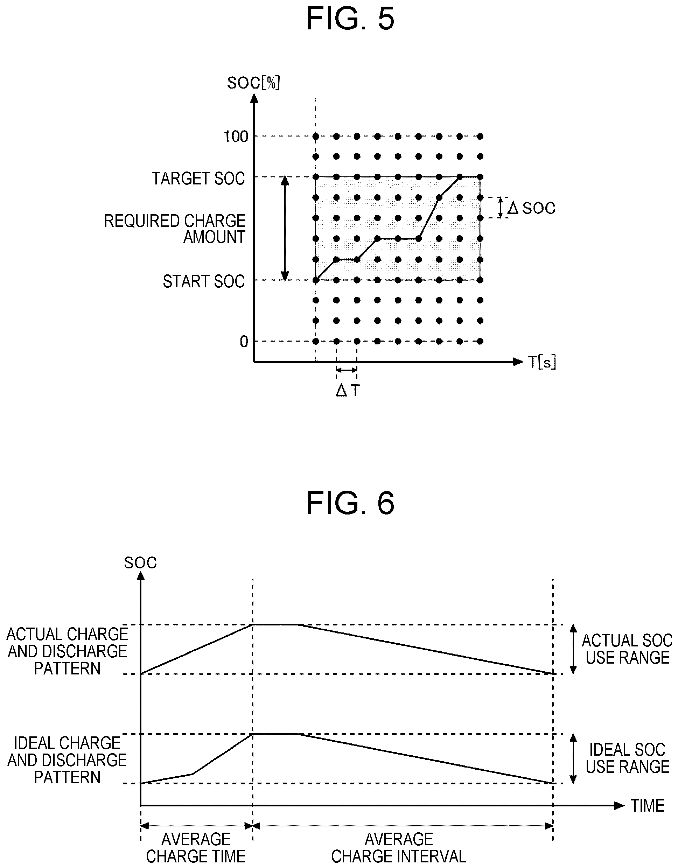

Fig. 5 is a diagram illustrating an example of the charge route search. Fig. 5 illustrates an example in which the charge start SOC is 30% and the charge target SOC is 80%. A required charge amount corresponds to the power amount corresponding to the DOD in the ideal SOC use range. Charge plan creation unit 17 searches for an optimal route from the charge start SOC to the charge target SOC within the charge period of the actual charge and discharge pattern.

The description refers back to Fig. 2. Ideal charge and discharge pattern generation unit 18 combines a current pattern of the charge plan created by charge plan creation unit 17 and the current pattern in the non-charge period of the actual charge and discharge pattern to generate an ideal charge and discharge pattern in the ideal SOC use range determined by ideal SOC range calculation unit 16. For simplification, the creation of the optimal charge plan by charge plan creation unit 17 may be omitted, and ideal charge and discharge pattern generation unit 18 may use the current pattern in the charge period of the actual charge and discharge pattern as a current pattern of general CC-CV charge.

Fig. 6 illustrates an example of the actual charge and discharge pattern and the ideal charge and discharge pattern. In the example illustrated in Fig. 6, the charge plan of the ideal charge and discharge pattern is changed to a charge pattern in which deterioration is more suppressed than the charge pattern of the actual charge and discharge pattern.

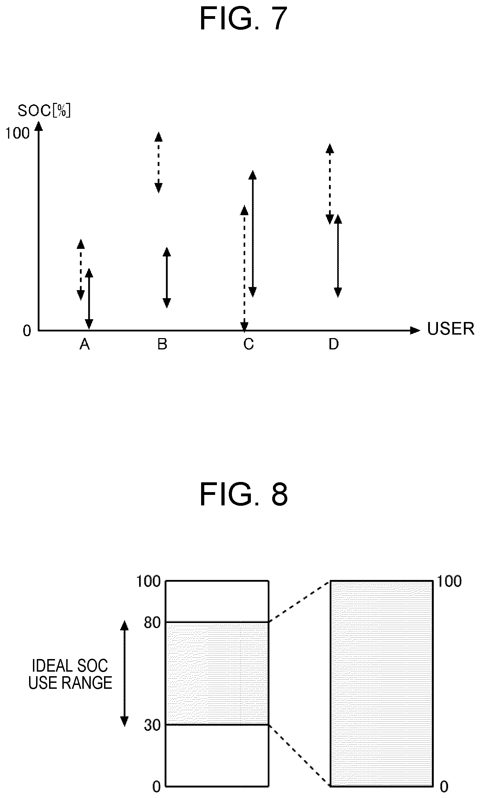

Fig. 7 illustrates an example of the actual SOC use range and the ideal SOC use range for each user. A dotted line indicates the actual SOC use range, and a solid line indicates the ideal SOC use range. A degree of change from the actual SOC use range to the ideal SOC use range varies depending on a use state of battery pack 50 of each user.

The description refers back to Fig. 2. deterioration amount calculation unit 19 refers to charge deterioration characteristic map 23, discharge deterioration characteristic map 24, and storage deterioration characteristic map 25 to calculate the deterioration amount (hereinafter, referred to as an actual deterioration amount) of battery pack 50 based on a use history of the battery data in the target period. deterioration amount calculation unit 19 calculates the deterioration amount (hereinafter, referred to as the ideal deterioration amount) of battery pack 50 in the target period in a case where the use is switched to the use in the ideal SOC use range. For example, assuming that the ideal charge and discharge pattern in the ideal SOC use range is repeated in the target period, deterioration amount calculation unit 19 refers to charge deterioration characteristic map 23, discharge deterioration characteristic map 24, and storage deterioration characteristic map 25 to calculate the ideal deterioration amount of battery pack 50 in the target period.

As illustrated in the following (Equation 1), the deterioration amount is calculated by a sum of a charge deterioration amount derived with reference to charge deterioration characteristic map 23, a discharge deterioration amount derived with reference to discharge deterioration characteristic map 24, and a storage deterioration amount derived with reference to storage deterioration characteristic map 25. In the calculation of the charge deterioration amount and the discharge deterioration amount, the temperature may also be included in a parameter. In the calculation of the ideal deterioration amount, an average temperature in the target period may be used as the temperature, or the normal temperature may be assumed. Deterioration amount = Charge deterioration amount (SOC, current rate) + discharge deterioration amount (SOC, current rate) + Storage deterioration amount (SOC, temperature)

Deterioration index calculation unit 110 calculates a deterioration improvement index indicating a degree of improvement in the deterioration amount of battery pack 50 in a case where the SOC use range is changed to the ideal SOC range based on the calculated actual deterioration amount and ideal deterioration amount. Deterioration index calculation unit 110 calculates a deterioration improvement index based on, for example, the following (Equation 2). The deterioration improvement index is a score indicating a life extension rate of battery pack 50. Deterioration improvement index [%] = 100 × (Actual deterioration amount/Ideal deterioration amount)

Deterioration index calculation unit 110 sets a state of health (SOH) to be a life of battery pack 50, and estimates a remaining life (the number of days until the SOH set to the life) in a case where a present use method is continued based on the present SOH and the actual deterioration amount. Similarly, deterioration index calculation unit 110 calculates the remaining life in a case where the SOC use range is changed to the ideal SOC range based on the present SOH and the ideal deterioration amount. Deterioration index calculation unit 110 may use, as the deterioration improvement index, an increase in the number of days of the remaining life in a case where the SOC is changed to the ideal SOC range.

When the user operates operation unit 40 to select a battery mode setting from setting items, display controller 112 displays options of a normal mode and a long life mode on display unit 30. At that time, display controller 112 displays the deterioration improvement index calculated by deterioration index calculation unit 110 as a guideline of deterioration improvement in a case where the normal mode is changed to the long life mode on display unit 30. The long life mode is a deterioration suppression mode of battery pack 50, and is a mode in which battery pack 50 is used in the ideal SOC use range. Basically, the deterioration improvement index is only presented to the user as a determination material for the user, and is not used for charge and discharge control.

When the long life mode is selected, display SOC generation unit 111 displays a remaining battery level obtained by normalizing the ideal SOC use range to a predetermined numerical value range on display unit 30. Fig. 8 is a diagram illustrating an example of normalization of the display SOC. A left SOC range indicates the SOC range corresponding to an actual capacity of battery pack 50. In the example illustrated in Fig. 8, the ideal SOC use range is set to a range of 30 to 80. A right SOC range indicates a display SOC range. In the example illustrated in Fig. 8, the range of 30 to 80 on an actual SOC scale is normalized to a range of 0 to 100, and the display SOC range is set. The ideal SOC use range in the actual SOC scale may be converted into a range of α - β with a margin. For example, α may be set to 10%. For example, β may be set to 90%. In the present exemplary embodiment, display SOC generation unit 111 displays the remaining battery level on display unit 30 at an upper limit value of the ideal SOC use range in a state where the SOC corresponding to the actual capacity of battery pack 50 exceeds an upper limit value of the ideal SOC use range, displays the remaining battery level on the display unit at a lower limit value of the ideal SOC use range in a state where the actual SOC falls below the lower limit value of the ideal SOC use range, and displays the actual SOC on display unit 30 as the remaining battery level as it is in a state where the actual SOC falls between the upper limit value and the lower limit value of the ideal SOC use range, which are also included in the concept of the display of the normalized remaining battery level.

In the long life mode, display SOC generation unit 111 calculates the display SOC based on the following (Equation 3) based on the ideal SOC use range and the present SOC of battery pack 50. Display SOC = (present SOC - lower limit of ideal SOC use range) × (100/upper limit SOC of ideal SOC use range - lower limit SOC of ideal SOC use range)

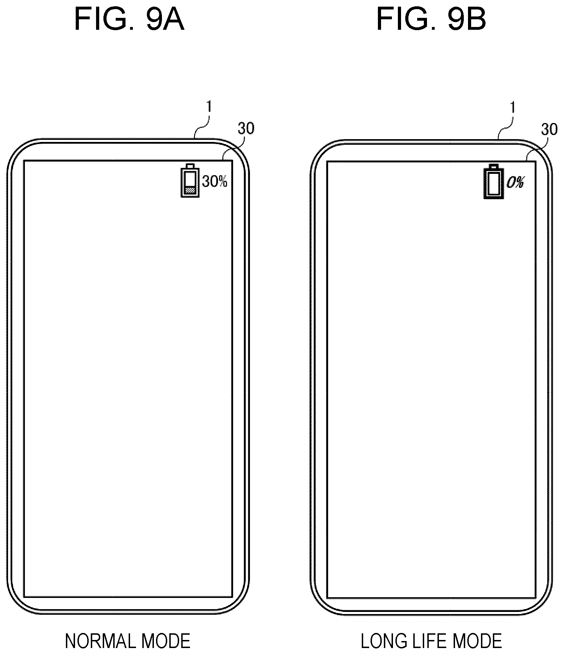

Fig. 9A illustrates a display example of the remaining battery level in the normal mode, and Fig. 9B illustrates a display example of the remaining battery level in the long life mode. When the normal mode is changed to the long life mode in a state where the actual remaining battery level is 30%, the display of the remaining battery level is changed from 30% to 0%.

In a case where the remaining battery level obtained by normalizing the ideal SOC use range to a range of 0 to 100 is displayed, display controller 112 displays the remaining battery level in a display mode in which the user can recognize that the display mode is the long life mode. In a case where the long life mode is selected, for example, display controller 112 changes color or a line thickness of a battery mark or changes a design of a battery mark. In addition, in a case where the remaining battery level is displayed as a numerical value, display controller 112 changes color, thickness, typeface, and the like of the numerical value.

The description refers back to Fig. 2. When battery pack 50 is charged, charge and discharge controller 113 sets a current command value or a voltage command value in charger 60 based on the charge plan created by charge plan creation unit 17. In a case where the creation of the optimal charge plan is omitted, charge and discharge controller 113 sets the current command value or the voltage command value in charger 60 according to a current pattern of general CC-CV charge.

At the time of charging in the long life mode, when the SOC of battery pack 50 reaches the upper limit SOC of the ideal SOC use range, charge and discharge controller 113 sets a charge stop instruction to charger 60 to stop charging of battery pack 50. The display SOC may be fixed to 100% in a range between the upper limit SOC of the ideal SOC use range and 100% of the actual SOC scale without stopping charging even though the SOC reaches the upper limit SOC of the ideal SOC use range.

At the time of discharging in the long life mode, when the SOC of battery pack 50 reaches the lower limit SOC of the ideal use SOC range, charge and discharge controller 113 sets a discharge stop instruction to charger 60 to stop discharging from battery pack 50. When the SOC reaches the lower limit SOC of the ideal SOC use range, display controller 112 may display a message prompting charging on display unit 30. In an emergency, switching from the long life mode to the normal mode is performed, and thus, the user can actually use the capacity remaining in battery pack 50.

In addition, even though the SOC reaches the lower limit SOC of the ideal SOC use range, discharging may not be prohibited. In this case, the display SOC is fixed at 0% in a range between the lower limit SOC of the ideal SOC range and 0% of the actual SOC scale. In this specification, the user can use the remaining capacity of battery pack 50 without returning to the normal mode.

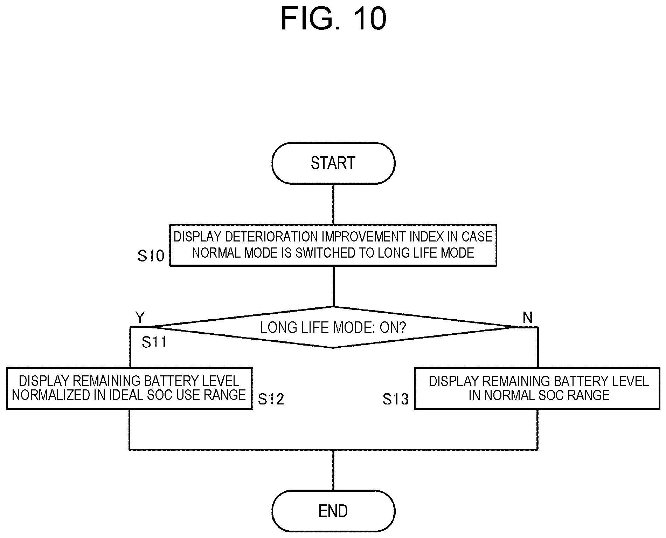

Fig. 10 is a flowchart illustrating a switching control example of the battery mode in battery-mounted device 1 according to the exemplary embodiment. When the user operates operation unit 40 to select the setting of the battery mode from the setting items, display controller 112 displays a battery mode setting screen including the deterioration improvement index of battery pack 50 on display unit 30 in a case where the normal mode is switched to the long life mode (S10). The user can determine whether to switch or not to the long life mode by looking at the displayed deterioration improvement index. In a case where the deterioration improvement index exceeds a predetermined value, display controller 112 may display a message recommending switching to the long life mode.

When the user selects the long life mode (Y in S11), display controller 112 displays the remaining battery level normalized in the ideal SOC use range on display unit 30 (S12). In a case where the user does not select the long life mode (N in S11), display controller 112 displays the remaining battery level in the normal SOC range on display unit 30 (S13).

As described above, in the present exemplary embodiment, display controller 112 displays a display prompting the user to use battery pack 50 in the ideal SOC use range on display unit 30. For example, the remaining battery level normalized in the ideal SOC use range is displayed, and thus, it is possible to guide each user to perform optimal charge corresponding to the use state by each user. The user can perform charging in which deterioration is suppressed in a naturally induced manner without being particularly conscious of a charge amount and a charge timing.

Even though the user intends to fully charge the battery, the battery is actually charged only up to the upper limit of the ideal SOC use range. Similarly, even though the user intends to use the entire capacity, the discharge is actually performed only up to the lower limit of the ideal SOC use range. That is, the SOC use range of battery pack 50 can be naturally converged within the optimal SOC use range in which the deterioration is suppressed without the user's particular consciousness. As a display prompting the user to use battery pack 50 in the ideal SOC use range, the display illustrated in a left diagram of Fig. 8 may be performed.

In addition, the user does not need to input use conditions and the like to battery-mounted device 1. As described above, it is possible to realize the use of battery pack 50 in which the optimal deterioration is suppressed for each user without applying labor and burden of data input to the user. The deterioration suppression method according to the present exemplary embodiment is particularly effective for a device that does not necessarily need to be charged up to full charge with large-capacity battery pack 50. Since the deterioration suppression method according to the present exemplary embodiment is not deterioration suppression control on the premise of full charge, it is possible to suppress deterioration of battery pack 50 while ensuring convenience for various usages.

The present disclosure has been described heretofore according to the exemplary embodiment. It will be understood by those skilled in the art that the exemplary embodiment is merely an example, other modified examples in that components and processing processes of the exemplary embodiments are variously combined are possible, and such modified examples still fall within the scope of the present disclosure.

In the above exemplary embodiment, when the actual SOC use range is changed to the ideal SOC use range, the same DOD is used. In this regard, strictly speaking, even in the SOC range of the same DOD, a maximum outputtable power [W] varies depending on a position of the SOC range. As the SOC range decreases, a discharge voltage decreases, and the maximum outputtable power [W] decreases.

Display controller 112 may display a maximum outputtable power [W] obtained from the actual SOC use range and a maximum outputtable power [W] obtained from the ideal SOC use range in the long life mode on a setting screen of the battery mode. In a case where battery-mounted device 1 is an electric vehicle, since the maximum outputtable power [W] affects acceleration, it is preferable to present a change in the maximum outputtable power [W] to the user.

Ideal SOC range calculation unit 16 may set the maximum outputtable power [W] obtained from the actual SOC use range as a constraint condition when the ideal SOC use range is calculated. Ideal SOC range calculation unit 16 may widen the ideal SOC use range depending on a position of the ideal SOC use range depending on the contract condition.

In the above exemplary embodiment, the example in which battery-mounted device 1 executes the generation of the histogram, the generation of the ideal SOC use range, and the creation of the charge plan in an offline standalone configuration has been described. In this regard, the deterioration suppression system may be formed in an online configuration. In this case, battery-mounted device 1 is connected to a server via a network, and transmits the battery data from battery-mounted device 1 to the server. The server executes the generation of the histogram, the generation of the ideal SOC use range, and the creation of the charge plan based on the received battery data, and transmits the ideal SOC use range and the charge plan to battery-mounted device 1.

In the case of the online configuration, battery data acquisition unit 11, histogram generation unit 13, actual SOC range calculation unit 14, actual charge and discharge pattern generation unit 15, ideal SOC range calculation unit 16, charge plan creation unit 17, ideal charge and discharge pattern generation unit 18, deterioration amount calculation unit 19, and deterioration index calculation unit 110 in Fig. 2 are provided on the server side. SOC estimation unit 12, display SOC generation unit 111, display controller 112, and charge and discharge controller 113 are provided on battery-mounted device 1 side.

As described above, when the use state of battery pack 50 by the user is managed by the histogram, the average value of the charge times, and the average value of the charge intervals, an operation can be performed such that the histogram, the average value of the charge times, and the average value of the charge intervals are integrated by difference calculation. In this case, a retention amount of the battery data can be reduced. In addition, a calculation amount can also be reduced. Thus, the deterioration suppression method according to the present exemplary embodiment does not require a high-spec processor, and can be realized at low cost even in the offline standalone configuration.

The exemplary embodiment may be defined by items below.

### [Item 1]

Deterioration suppression system (10) including
histogram generation unit (13) that generates a histogram of a duration of stay time of state of charge (SOC) of battery (50) based on the battery data,
actual SOC range calculation unit (14) that calculates, as an actual SOC use range, an SOC range that falls within a predetermined appearance probability from the histogram,
recommended SOC range calculation unit (16) that calculate a recommended SOC use range in which deterioration is more suppressed than from the actual SOC use range based on a statistical charge and discharge pattern based on the actual SOC use range and the battery data, with refers to deterioration characteristics of battery (50) and
display controller (112) that causes display unit (30) to display a display prompting a user to use battery (50) in the recommended SOC use range. The recommended SOC use range may coincide with the ideal SOC use range, or may be the SOC use range obtained by adding a predetermined margin to the ideal SOC use range.

Accordingly, it is possible to promote the use of battery (50) in which deterioration is suppressed to be suitable for each user without requiring the input of the use condition.

### [Item 2]

Deterioration suppression system (10) according to Item 1, in which display controller (112) displays a remaining battery level obtained by normalizing the recommended SOC use range to a predetermined numerical value range on display unit (30).

Accordingly, the user can be naturally prompted to use battery (50) in the optimal SOC use range.

### [Item 3]

Deterioration suppression system (10) according to Item 2, in which display controller (112) displays the remaining battery level obtained by normalizing the recommended SOC use range to the predetermined numerical value range in a display mode in which the user is configured to recognize that the display mode is a long life mode.

Accordingly, in a state where the long life mode is selected, the user can recognize that a present battery mode is the long life mode.

### [Item 4]

Deterioration suppression system (10) according to Item 1 further including charge plan creation unit (17) that creates a charge plan in which deterioration is more suppressed than a charge pattern of the statistical charge and discharge pattern based on a charge time of the statistical charge and discharge pattern, the recommended SOC use range, the charge deterioration characteristic and a storage deterioration characteristic of battery (50).

Accordingly, deterioration of battery (50) during charging can be suppressed more than during normal use.

### [Item 5]

Deterioration suppression system (10) according to any one of Items 1 to 4 further including
deterioration amount calculation unit (19) that refers to a charge deterioration characteristic, a discharge deterioration characteristic, and a discharge deterioration characteristic of battery (50) to calculate a deterioration amount of battery (50) calculated based on a use history of the battery data in a target period and a deterioration amount of battery (50) in the target period in a case where use is switched to use in the recommended SOC use range, in which
display controller (112) displays an index indicating a degree of improvement of the deterioration amount of battery (50) when the use is switched to the use in the recommended SOC use range on display unit (30).

Accordingly, it is possible to present a determination material as to whether or not to select the long life mode to the user.

### [Item 6]

A deterioration suppression method including
generating a histogram of a duration of stay time of state of charge (SOC) of battery (50) based on battery data,
calculating, as an actual SOC use range, an SOC range that falls within a predetermined appearance probability from the histogram,
calculating a recommended SOC use range in which deterioration more suppressed than the actual SOC use range based on a statistical charge and discharge pattern based on the actual SOC use range and the battery data referring to the deterioration characteristics of battery (50), and
causing a display unit (30) to display a display prompting a user to use battery (50) in the recommended SOC use range.

Accordingly, it is possible to promote the use of battery (50) in which deterioration is suppressed to be suitable for each user without requiring the input of the use condition.

### [Item 7]

A deterioration suppression program for causing a computer to execute a process including
generating a histogram of a duration of stay time of state of charge (SOC) of battery (50) based on battery data acquired from the battery,
calculating, as an actual SOC use range, an SOC range that falls within a predetermined appearance probability from the histogram,
calculating a recommended SOC use range in which deterioration is more suppressed than the actual SOC use range based on a statistical charge and discharge pattern based on the actual SOC use range and the battery data, referring to deterioration characteristics of battery (50) and
causing a display unit (30) to display a display prompting a user to use battery (50) in the recommended SOC use range.

Accordingly, it is possible to promote the use of battery (50) in which deterioration is suppressed to be suitable for each user without requiring the input of the use condition.

### REFERENCE MARKS IN THE DRAWINGS

- 1: battery-mounted device
- 2: commercial power system
- 3: AC adapter
- 10: controller
- 11: battery data acquisition unit
- 12: SOC estimation unit
- 13: histogram generation unit
- 14: actual SOC range calculation unit
- 15: actual charge and discharge pattern generation unit
- 16: ideal SOC range calculation unit
- 17: charge plan creation unit
- 18: ideal charge and discharge pattern generation unit
- 19: deterioration amount calculation unit
- 110: deterioration index calculation unit
- 111: display SOC generation unit
- 112: display controller
- 113: charge and discharge controller
- 20: storage unit
- 21: battery data retention unit
- 22: histogram retention unit
- 23: charge deterioration characteristic map
- 24: discharge deterioration characteristic map
- 25: storage deterioration characteristic map
- 30: display unit
- 40: operation unit
- 50: battery pack
- 51: voltage sensor
- 52: current sensor
- 53: temperature sensor
- 60: charger

## Claims

1. A deterioration suppression system comprising:
a histogram generation unit that generates a histogram of a duration of stay time of state of charge (SOC) of a battery based on battery data acquired from the battery;
an actual SOC range calculation unit that calculates, as an actual SOC use range, an SOC range that falls within a predetermined appearance probability from the histogram;
a recommended SOC range calculation unit that calculates a recommended SOC use range in which deterioration is more suppressed than the actual SOC use range based on a statistical charge and discharge pattern based on the actual SOC use range and the battery data, with refers to deterioration characteristics of the battery; and
a display controller that causes a display unit to display a display prompting a user to use the battery in the recommended SOC use range.

2. The deterioration suppression system according to Claim 1, wherein the display controller displays a remaining battery level obtained by normalizing the recommended SOC use range to a predetermined numerical value range on the display unit.

3. The deterioration suppression system according to Claim 2, wherein the display controller displays the remaining battery level obtained by normalizing the recommended SOC use range to the predetermined numerical value range in a display mode in which the user is configured to recognize that the display mode is a long life mode.

4. The deterioration suppression system according to Claim 1, further comprising
a charge plan creation unit that creates a charge plan in which deterioration is more suppressed than a charge pattern of the statistical charge and discharge pattern based on a charge time of the statistical charge and discharge pattern, the recommended SOC use range, and a charge deterioration characteristic and a storage deterioration characteristic of the battery.

5. The deterioration suppression system according to any one of Claims 1 to 4, further comprising
a deterioration amount calculation unit that refers to a charge deterioration characteristic, a discharge deterioration characteristic, and a discharge deterioration characteristic of the battery to calculate a deterioration amount of the battery calculated based on a use history of the battery data in a target period and a deterioration amount of the battery in the target period in a case where use is switched to use in the recommended SOC use range,
wherein the display controller displays an index indicating a degree of improvement of the deterioration amount of the battery when the use is switched to the use in the recommended SOC use range on the display unit.

6. A deterioration suppression method comprising:
generating a histogram of a duration of stay time of state of charge (SOC) of a battery based on battery data acquired from the battery;
calculating, as an actual SOC use range, an SOC range that falls within a predetermined appearance probability from the histogram;
calculating a recommended SOC use range in which deterioration more suppressed than the actual SOC use range based on a statistical charge and discharge pattern based on the actual SOC use range and the battery data, referring to deterioration characteristics of the battery; and
displaying a display prompting a user to use the battery in the recommended SOC use range.

7. A deterioration suppression program for causing a computer to execute a process comprising:
generating a histogram of a duration of stay time of state of charge (SOC) of a battery based on battery data acquired from the battery;
calculating, as an actual SOC use range, an SOC range that falls within a predetermined appearance probability from the histogram;
calculating a recommended SOC use range in which deterioration is more suppressed than the actual SOC use range based on a statistical charge and discharge pattern based on the actual SOC use range and the battery data, referring to deterioration characteristics of the battery; and
causing a display unit to display a display prompting a user to use the battery in the recommended SOC use range.

8. A non-transitory storage medium describing the deterioration suppression program according to Claim 7.
